# EUROPEAN PATENT APPLICATION

(11) **EP 3 376 506 A1**
(43) Date of publication of application: **19.09.2018**
(21) Application number: 18161281.3
(22) Date of filing: 12.03.2018
(51) Int. Cl.: G21C 3/07, C23C 16/32, C04B 35/565, C23C 16/48, G21C 3/20, G21C 21/02

(54) **METHOD OF MANUFACTURE**

(30) Priority: 15.03.2017 GB 201704089
(71) Applicant: Rolls-Royce Power Engineering PLC, Derby DE24 8BJ (GB)
(72) Inventor: Neall, Roxanne, Derby, DE24 8BJ (GB)
(74) Representative: Rolls-Royce plc

(57) **Abstract**

A method of manufacturing a nuclear fuel rod comprises providing a tubular substrate (26) in a vacuum chamber (46). The method comprises using laser driven chemical vapour deposition to form a plurality a fibres (48) within the vacuum chamber (46) and as the fibres (48) are formed, weaving the fibres around the substrate (26).

## Description

### TECHNICAL FIELD

The present disclosure concerns a fuel rod, a nuclear power plant, a component, a method of manufacturing a component and/or a method of manufacturing nuclear fuel.

### BACKGROUND

A nuclear power plant generally includes a nuclear reactor, a primary circuit, a heat exchanger, a secondary circuit, and a turbine. The primary fluid in the primary circuit is heated by the nuclear reactor. The primary fluid flows to the heat exchanger, where it heats secondary fluid in the secondary circuit. The heated secondary fluid is then used to drive the turbine to generate electricity.

The nuclear reactor generally includes a plurality of fuel rods. Fuel rods are rods that contain nuclear fuel. Typically, a fuel rod is a tubular member containing uranium dioxide pellets. The fuel rod is clad in a zirconium alloy, commonly referred to a zircaloy. The zirconium alloy typically has at least 95% by weight zirconium, and the remainder is made up of other metallic elements.

Zirconium has a very low absorption of thermal neutrons, is hard, ductile, corrosion resistant and has a high thermal conductivity, which are the properties needed for the cladding of a nuclear fuel rod. However, zircaloy reacts with steam to produce hydrogen in an exothermic reaction. As such, a power plant needs to include many active control measures to handle hydrogen in an accident scenario. Accordingly, there is a move in the industry to improve the accident resistance of nuclear fuel rods.

Ceramic cladding, such as silicon carbide has been considered for use as a cladding material. Ceramic cladding has a higher melting point than zircaloy and does not form large amounts of hydrogen when it contacts steam, so it is more accident resistant.

Proposed silicon carbide cladding often includes a monolithic tube of silicon carbide that is manufactured using chemical vapour deposition (CVD). In the process of CVD a heat source (e.g. a heat mat) is required, and this can cause variation in the properties of the resulting tube, with the material closer to the heat source having different properties to material distal to the heat source. Once the complete tube is manufactured, it may be reinforced, by forming a weave of silicon carbide fibres around the tube. The fibres may be, by way of example only, manufactured using a method similar to that described in US2015004393. Once the layers of weave are formed, they are filled with a silicon carbide matrix by chemical vapour infiltration and then polymer impregnation pyrolysis. The resulting structure has a larger surface area, so a barrier coating is applied to the infiltrated weave.

### SUMMARY

According to an aspect there is provided a method of manufacturing nuclear fuel. The method comprises providing a substrate in a vacuum chamber. Laser driven chemical vapour deposition is used to form a plurality a fibres within the vacuum chamber and as the fibres are formed, they are woven around the substrate.

The fibres may be considered to be formed in-situ, that is, they are formed as they are woven around the substrate.

The nuclear fuel may be a nuclear fuel rod. The substrate may be a tubular substrate.

The method may comprise depositing a matrix material on the fibres that are woven around the substrate.

Forming the fibres in-situ and forming the weave in-situ, means that the matrix material can be applied at a suitable time for improved infill of the matrix material into the composite weave. For example, matrix material may be applied after each layer of weave is formed, rather than forming all the weave layers and then infilling the weaves with matrix material.

The matrix material may be deposited using selective area laser deposition.

The matrix material may be applied in the vacuum chamber.

Once the fibres are woven around the substrate, a matrix material may be deposited on the fibres to infill a weave formed by the fibres, then further fibres may be woven around the substrate, and further matrix material may be deposited on the weave layers formed.

The fibres and/or the matrix material may be made from silicon carbide.

The substrate may be made from silicon carbide (e.g. monolithic silicon carbide).

The substrate may be made from graphite.

Once the fibres have been formed and weaved around the substrate, the method may comprise placing the assembly of tubular substrate and woven fibres in an oven at elevated temperature so as to remove the graphite from the assembly.

The method may comprise depositing a matrix material on the fibres, then weaving a further plurality of fibres around the matrix material. This process may be repeated a plurality of times, until the desired number of fibre composite weave layers are formed.

In an aspect there is provided an apparatus for manufacturing a nuclear fuel rod according to the previous aspect.

The apparatus may comprise a vacuum chamber and a plurality of laser heads connected to one or more laser beams for forming the fibres. The apparatus may comprise one or more sources of vapour for forming the desired material of the fibres. The apparatus may comprise a manipulator for moving the substrate through and/or rotating the substrate in the vacuum chamber, and/or for moving the laser heads around and/or along the substrate.

The vacuum chamber may include a substrate inlet and a substrate outlet. The manipulator may be arranged to move the substrate through the vacuum chamber in a direction from the inlet to the outlet.

The apparatus may comprise a further laser for depositing a matrix material on a fibre weave formed in the apparatus using the one or more sources of vapour.

An aspect may provide a nuclear fuel rod comprising a fuel core and a weave composite comprising a weave of ceramic fibres proximal to the core and a matrix material provided on and between the weave of the ceramic fibres.

The weave composite may be provided directly adjacent the fuel core with no intervening layer or only a gap between the weave composite and the fuel core.

In an aspect there is provided a method of manufacturing a ceramic component. The method comprises providing a substrate in a vacuum chamber and using laser driven chemical vapour deposition to form a plurality a fibres within the vacuum chamber. As the fibres are formed, the fibres are woven onto or around the substrate.

In an aspect there is provided a nuclear fuel rod manufactured using a method of one of the previous aspects.

The skilled person will appreciate that except where mutually exclusive, a feature described in relation to any one of the above aspects may be applied mutatis mutandis to any other aspect. Furthermore except where mutually exclusive any feature described herein may be applied to any aspect and/or combined with any other feature described herein.

### DESCRIPTION OF THE DRAWINGS

Embodiments will now be described by way of example only, with reference to the Figures, in which:
**Figure 1** is a schematic of a nuclear power plant;
**Figure 2** is a schematic cross sectional view of a fuel rod;
**Figure 3** is a schematic of equipment used for forming a monolithic ceramic tube; and
**Figure 4** is a schematic of equipment used in the manufacture of a fuel rod; and
**Figure 5** is a schematic cross sectional view of an alternative fuel rod.

### DETAILED DESCRIPTION

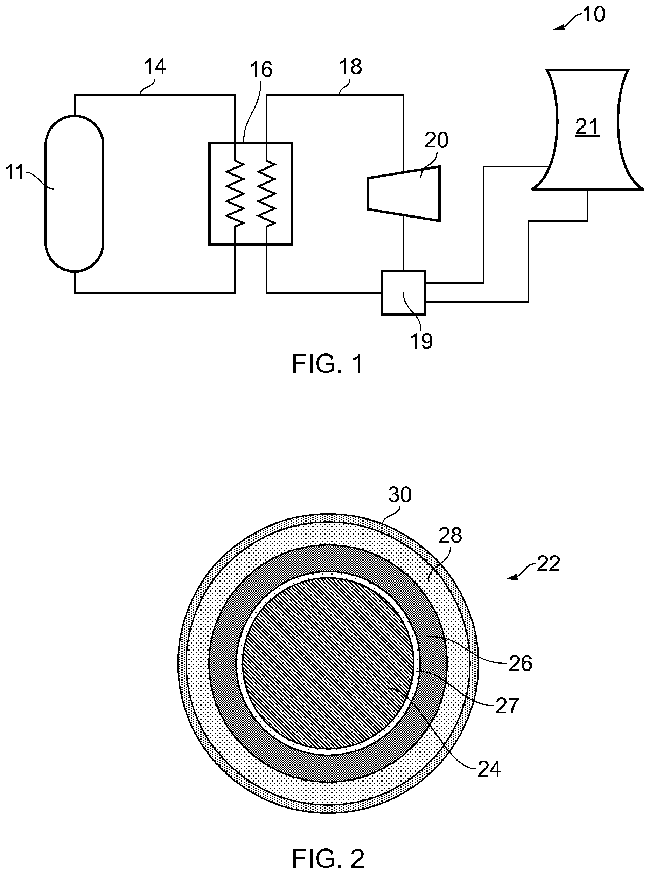

Referring to Figure 1, a nuclear power plant is indicated generally at 10. The plant includes a reactor vessel 11 housing nuclear fuel, a primary circuit 14, a heat exchanger which in this example is a steam generator 16, a secondary circuit 18 and a turbine 20. The primary fluid in the primary circuit is heated by the nuclear reactor. The primary fluid then flows to the steam generator, where it heats secondary fluid, in this example water, in the secondary circuit. The heated secondary fluid is then used to drive the turbine 20. The secondary fluid then flows to a condenser 19 where it is cooled using water from an ultimate heat sink 21. The ultimate heat sink may be a cooling tower, river, lake, or any other suitable supply of cooling water.

The nuclear reactor includes a plurality of fuel rods. There are different arrangements of fuel rods, but an example of a fuel rod with ceramic cladding is illustrated generally at 22 in Figure 2. Each fuel rod 22 includes fuel core 24. The fuel core contains fissile material, for example the fuel may contain isotopes of uranium or plutonium, e.g. uranium-235, plutonium-239, or plutonium 241. An example fuel that may be used is uranium silicide (U₃Si₂).

The fuel core 24 is surrounded by a ceramic tube, in this example a monolithic silicon carbide tube 26. A gas gap 27 is provided between the fuel core 24 and the tube 26. The tube 26 is surrounded by a composite weave layer 28, which in this example comprises ceramic fibres in a matrix, in this example the fibres are silicon carbide fibres and the matrix is silicon carbide. The composite weave layer 28 is covered in an environmental barrier coating 30. The environmental barrier coating may be a further layer of silicon carbide.

A method of manufacturing the assembly that surrounds the fuel core 24 of the fuel rod 22 will now be described in more detail.

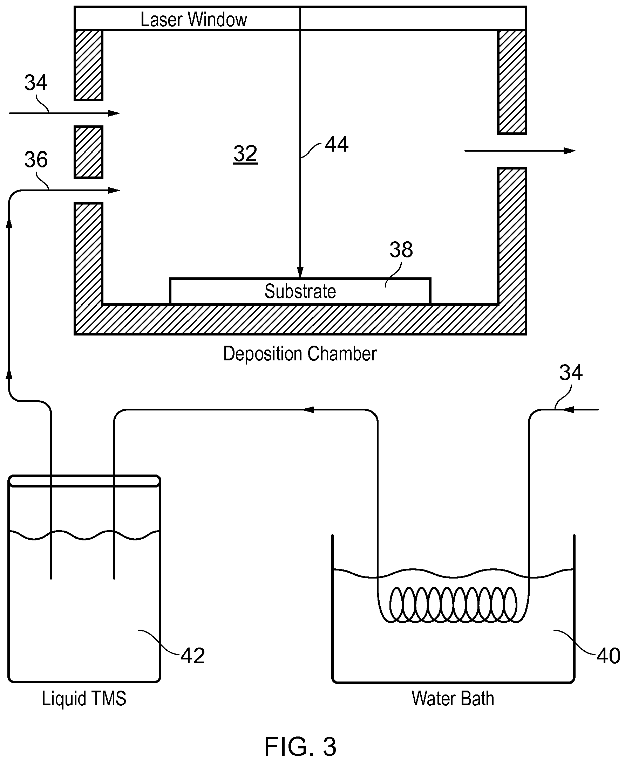

Referring to Figure 3, the monolithic tube 26 is manufactured using selective area laser deposition (SALD), but in alternative embodiments the tube may be manufactured using an alternative method such as chemical vapour deposition. To manufacture the tube 26 using SALD, a deposition chamber 32, inert gas source 34, precursor material source 36, and substrate 38 are provided. The deposition chamber 32 is brought down to a reduced pressure where any remaining atmosphere is nitrogen or an inert gas which enters at the source 34. The nitrogen is warmed to the boiling point of the precursor material that will be used in the SALD using a water bath 40. Precursor vapour is picked up from a reservoir of liquid precursor 42, by the heated nitrogen flow and is delivered to the deposition chamber. In this example, the precursor is Tetramethylsilane (TMS). A laser 44 scans over the surface of the substrate 38, which locally heats and decomposes the TMS vapour to form silicon carbide on the substrate. Once the tube is formed, the substrate can be removed from the tube using known methods in the art.

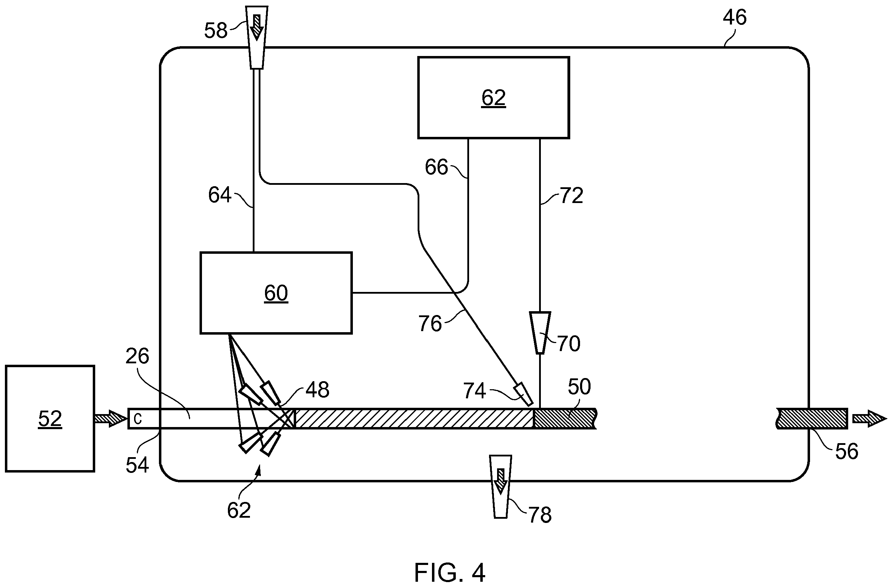

Referring now to Figure 4, the monolithic tube 26 can be passed through a pressure controlled chamber 46, and the composite weave layer 28 can be defined by fibres 48 and a matrix material 50.

A manipulator 52 is provided to move the monolithic tube 26 through the pressure controlled chamber 46 from an inlet 54 to an outlet 56. In the present example, this is linearly in a direction of the longitudinal axis of the monolithic tube. The manipulator 52 is also arranged to rotate the monolithic tube as it passes through the pressure controlled chamber. However, in alternative embodiments, the manipulator may not rotate the tube and instead the lasers (described later) may be rotated about the tube.

The pressure controlled chamber 46 includes a precursor vapour input 58. The precursor in this example is Tetramethylsilane (TMS).

One or more laser sources 62 are provided in the pressure controlled chamber 46.

The pressure controlled chamber 46 also includes an arrangement 60 for manufacturing silicon carbide fibres. A precursor flow line 64 is provided from the precursor vapour input 58 to the arrangement 60. A laser conduit 66 is provided from the one or more laser sources 62 to multiple laser heads 68. The laser heads 68 are dimensioned and arranged to be capable of forming fibres using laser directed chemical vapour deposition (similar to that described in US2015004393). The laser heads 68 are provided as close as possible to the path of the tube 26 through the pressure controlled chamber.

A further laser head 70 is provided downstream of the arrangement 60 and laser heads 68. A further laser conduit 72 extends from the laser source 62 to the head 70. A precursor dispenser 74 is provided adjacent the laser head and tube path, and a flow path 76 of precursor is provided between the precursor vapour inlet and the dispenser 74.

A product exhaust output 78 is provided for exhausting waste products from the pressure controlled chamber.

To apply the composite weave layer 28 to the tube 26, the manipulator passes the tube through the inlet 54. The arrangement 60 and laser heads 68 then form a plurality of fibres. The laser heads are angled and spaced from the tube such that the fibres are weaved around the tube whilst lengths of the fibres are being produced. The manipulator rotates the tube so that the fibres are weaved around the tube.

Once the tube has passed the multiple laser heads 68 and is wrapped with a weave of fibres, the laser head 70 and dispenser 74 are used to apply a matrix material to the tube using selective area laser deposition.

The tube can then pass out of the chamber. Alternatively, the tube may be passed back towards the lasers 68 and further fibre weave may be applied to the tube, and then the tube may optionally be moved towards the laser head 70 for a further layer of matrix material. This application of fibre weave and matrix material can be repeated as required. Further, the number of layers of fibre weave to matrix material can be varied as desired. In further alternative embodiments, a series of lasers for fibre production and lasers for matrix production may be provided sequentially.

Once manufactured, if desired an environmental barrier coating may be provided using conventional methods. However, the described method can provide a composite weave layer 28 that is less porous than a conventional composite weave layer, and as such an environmental barrier coating may not be required. The composite weave layer 28 is less porous than a conventional composite weave layer because the temperature is better controlled through the layer during production and the matrix is added between each fibre layer instead of being added only after all the fibre layers are produced, so there is better infiltration of the matrix material.

The described method provides for continuous processing of ceramic composite tubes which could be significantly faster than current CVD methods. It is predicted that production costs can be reduced using the described method. Furthermore, as will be described later, the described method can allow for increased flexibility in design of ceramic clad nuclear fuel rods.

The use of selective area laser deposition in the manufacturing process instead of the conventional use of CVD means that the properties of the cladding can be more homogeneous.

The fuel rod arrangement illustrated is exemplary only, and the fuel rod may have an alternative construction. For example, no gap may be provided in the fuel rod. Further the fuel rod may comprise alternative layers, for example, instead of a gas gap, a porous material may be provided, e.g. a carbon base material.

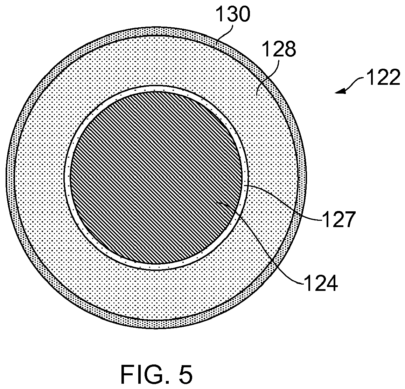

The described method of manufacture provides for more flexibility in the design of nuclear fuel rods. In the example shown in Figure 5, there is no monolithic tube shown, instead the fuel core 124 is surrounded by a gas gap 127, and a composite weave layer 128, and the composite weave layer is optionally coated with an environmental coating 130. To manufacture such a fuel rod, a similar method as previously described is used, but instead of passing a monolithic silicon carbide tube through the pressure controlled chamber 46, an alternative tube substrate is passed through the chamber, for example a graphite tube. The composite weave layer 128 is then formed on the graphite tube in the manner previously described. Once the composite weave layer 128 is formed, the composite weave layer and graphite tube are placed in an oven so as to remove the graphite tube. The composite weave layer produced by the described method of manufacture is less porous, so the need for a monolithic tube between the fuel core and the composite weave layer 128 can be removed.

In further examples, the number of layers of weave laid before being infilled with resin can be varied as desired.

The fuel rods have been described with reference to a pressurised water reactor (PWR), but they could be used with other types of power plants such as a boiling water reactor (BWR).

It will be understood that the invention is not limited to the embodiments above-described and various modifications and improvements can be made without departing from the concepts described herein. Except where mutually exclusive, any of the features may be employed separately or in combination with any other features and the disclosure extends to and includes all combinations and subcombinations of one or more features described herein.

## Claims

1. A method of manufacturing a nuclear fuel rod, the method comprising:
providing a tubular substrate in a vacuum chamber;
using laser driven chemical vapour deposition to form a plurality a fibres within the vacuum chamber; and
as the fibres are formed, weaving the fibres around the substrate.

2. The method according to claim 1, comprising depositing a matrix material on the fibres that are woven around the substrate.

3. The method according to claim 2, wherein the matrix material is deposited using selective area laser deposition.

4. The method according to claim 2 or 3, wherein the matrix material is applied in the vacuum chamber.

5. The method according to any one of claims 2 to 4, wherein fibres are woven around the substrate, then a matrix material is deposited on the fibres to infill a weave formed by the fibres, then further fibres are woven around the substrate and further matrix material is deposited on the weaves formed.

6. The method according to any one of the previous claims, wherein the fibres and/or the matrix material are made from silicon carbide.

7. The method according to any one of the previous claims, wherein the substrate is made from silicon carbide (e.g. monolithic silicon carbide).

8. The method according to any one of claims 1 to 6, wherein the substrate is made from graphite.

9. The method according to claim 8 comprising, once the fibres have been formed and weaved around the substrate, placing the assembly of tubular substrate and fibres in an oven at elevated temperature so as to remove the graphite from the assembly.

10. Apparatus for manufacturing a nuclear fuel rod according to any one of the previous claims, the apparatus comprising:
a vacuum chamber;
a plurality of laser heads connected to one or more laser beams for forming the fibres;
one or more sources of vapour for forming the desired material of the fibres; and
a manipulator for moving the substrate through and/or rotating the substrate in the vacuum chamber, and/or for moving the laser heads around and/or along the substrate.

11. The apparatus according to claim 10, wherein the vacuum chamber includes a substrate inlet and a substrate outlet, and the manipulator is arranged to move the substrate through the vacuum chamber in a direction from the inlet to the outlet.

12. The apparatus according to claim 10 or 11, comprising a further laser for depositing a matrix material on a fibre weave formed in the apparatus using the one or more sources of vapour.

13. A nuclear fuel rod comprising:
a fuel core; and
a weave composite comprising a weave of ceramic fibres proximal to the core and a matrix material provided on and between the weave of the ceramic fibres.

14. The fuel rod according to claim 13, wherein the weave composite is provided directly adjacent the fuel core with no intervening layer or only a gap between the weave composite and the fuel core.

15. A method of manufacturing a ceramic component, the method comprising:
providing a substrate in a vacuum chamber;
using laser driven chemical vapour deposition to form a plurality a fibres within the vacuum chamber; and
as the fibres are formed, weaving the fibres onto or around the substrate.
